# EUROPEAN PATENT APPLICATION

(11) **EP 4 325 675 A1**
(43) Date of publication of application: **21.02.2024**
(21) Application number: 22891388.5
(22) Date of filing: 13.05.2022
(51) Int. Cl.: H01S 5/42, H01S 5/183

(54) **VERTICAL-CAVITY SURFACE-EMITTING LASER AND PREPARATION METHOD**

(30) Priority: 11.11.2021 CN 202111331298
(71) Applicant: Vertilite Co., Ltd., Changzhou, Jiangsu (CN)
(72) Inventor: WENG, Weicheng, hangzhou, Jiangsu 213000 (CN); DING, Weizun, hangzhou, Jiangsu 213000 (CN); PENG, Junyan, hangzhou, Jiangsu 213000 (CN); LIU, Song, hangzhou, Jiangsu 213000 (CN); LIANG, Dong, hangzhou, Jiangsu 213000 (CN)
(74) Representative: Gill Jennings & Every LLP
(86) International application number: PCT/CN2022/092689
(87) International publication number: WO 2023/082577

(57) **Abstract**

Provided are a vertical cavity surface emitting laser and a manufacturing method thereof. The vertical cavity surface emitting laser includes a substrate (10), and emitters (20) arranged in an array, where the emitters (20) are located on a surface of the substrate (10). Each emitter (20) of the emitters is provided with a light emitting window (21), a via (22) and an oxidation trench (23), the light emitting window (21) is used for emitting light, the via (22) surrounds the light emitting window (21), the oxidation trench (23) surrounds the light emitting window (21), and at least one of the via (22) or the oxidation trench (23) is shared by at least two emitters (20), thereby reducing the size between emitters (20) in the vertical cavity surface emitting laser.

## Description

This application claims priority to Chinese Patent Application No. 202111331298.0 filed with the China National Intellectual Property Administration (CNIPA) on Nov. 11, 2021, the disclosure of which is incorporated herein by reference in its entirety.

### TECHNICAL FIELD

The present application relates to a technical field of semiconductors, for example, to a vertical cavity surface emitting laser and a manufacturing method thereof.

### BACKGROUND

A vertical cavity surface emitting laser (VCSEL) is developed on the basis of a gallium arsenide semiconductor material. The VCSEL has advantages such as small volume, low threshold current, high modulation frequency, and easiness in optical fiber coupling, which can be applied not only in the fields such as optical communication, optical interconnection, and optical information processing, but also in the fields of electronic consumption such as mobile phone and autonomous vehicle Lidar (light detection and ranging) as light sources for structured light technologies in 3-dimensional (3D) identification.

In order to achieve a small size vertical cavity surface emitting laser, it is necessary to continuously reduce the size between emitters in the vertical cavity surface emitting laser. However, it is limited by the configuration of the vertical cavity surface emitting laser in related art, the size between emitters cannot continue to be reduced.

### SUMMARY

Embodiments of the present application provide a vertical cavity surface emitting laser and a manufacturing method of the vertical cavity surface emitting laser.

An embodiment of the present application provides a vertical cavity surface emitting laser, including a substrate, and emitters arranged in an array, where the emitters are located on a surface of the substrate.

Each emitter is provided with a light emitting window, a via and an oxidation trench, the light emitting window is used for emitting light, the via surrounds the light emitting window, and the oxidation trench surrounds the light emitting window.

At least one of the via and the oxidation trench is shared by at least two of the emitters.

An embodiment of the present application further provides a manufacturing method of a vertical cavity surface emitting laser, and the method includes the steps described below.

A substrate is provided; and emitters arranged in an array is formed on a surface of the substrate.

Each emitter of the emitters is provided with a light emitting window, a via and an oxidation trench, the light emitting window is used for emitting light, the via surrounds the light emitting window, and the oxidation trench surrounds the light emitting window.

At least one of the via and the oxidation trench is shared by at least two of the emitters.

### BRIEF DESCRIPTION OF DRAWINGS

FIG. 1 is a top view of a vertical cavity surface emitting laser in related art;
FIG. 2 is a top view of another vertical cavity surface emitting laser in related art;
FIG. 3 is a sectional diagram taken along a line A1-A2 of FIG. 1;
FIG. 4 is a structural diagram of a vertical cavity surface emitting laser according to an embodiment of the present application;
FIG. 5 is a structural diagram of another vertical cavity surface emitting laser according to an embodiment of the present application;
FIG. 6 is a top view of another vertical cavity surface emitting laser according to an embodiment of the present application;
FIG. 7 is a sectional diagram taken along a line B 1-B2 of FIGS. 4 to 6;
FIG. 8 is a sectional diagram taken along a line B3-B4 of FIGS. 5 and 6;
FIG. 9 is a flowchart of a manufacturing method of a vertical cavity surface emitting laser according to an embodiment of the present application;
FIG. 10 is a flowchart included in step 120 of FIG. 9;
FIG. 11 is a flowchart included in step 1203 of FIG. 10;
FIG. 12 is a flowchart included in step 1204 of FIG. 10;
FIG. 13 is another flowchart included in step 1203 of FIG. 10;
FIG. 14 is a structural diagram corresponding to a step of a manufacturing method of a vertical cavity surface emitting laser according to an embodiment of the present application;
FIG. 15 is another structural diagram corresponding to a step of a manufacturing method of a vertical cavity surface emitting laser according to an embodiment of the present application;
FIG. 16 is another structural diagram corresponding to a step of a manufacturing method of a vertical cavity surface emitting laser according to an embodiment of the present application;
FIG. 17 is another structural diagram corresponding to a step of a manufacturing method of a vertical cavity surface emitting laser according to an embodiment of the present application;
FIG. 18 is another structural diagram corresponding to a step of a manufacturing method of a vertical cavity surface emitting laser according to an embodiment of the present application;
FIG. 19 is another structural diagram corresponding to a step of a manufacturing method of a vertical cavity surface emitting laser according to an embodiment of the present application;
FIG. 20 is another structural diagram corresponding to a step of a manufacturing method of a vertical cavity surface emitting laser according to an embodiment of the present application;
FIG. 21 is another structural diagram corresponding to a step of a manufacturing method of a vertical cavity surface emitting laser according to an embodiment of the present application; and
FIG. 22 is another structural diagram corresponding to a step of a manufacturing method of a vertical cavity surface emitting laser according to an embodiment of the present application.

### DETAILED DESCRIPTION

The present application is further described in detail hereinafter in conjunction with the drawings and embodiments. It is to be understood that the embodiments described herein are intended to illustrate and not to limit the present application. Additionally, it is to be noted that to facilitate description, only part, not all, of structures related to the present application are illustrated in the drawings.

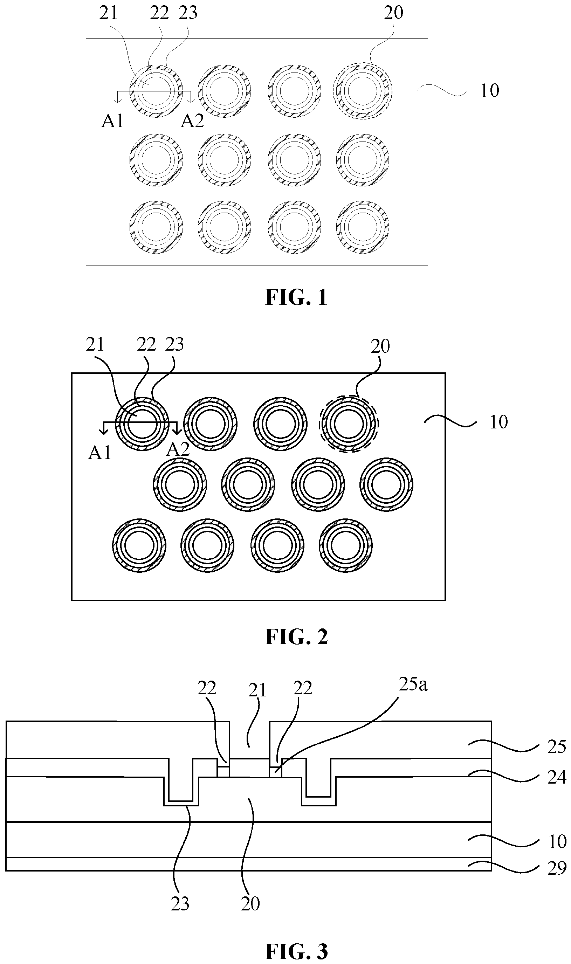

As described in the above background, since it is limited by the configuration of the vertical cavity surface emitting laser in related art, the size between emitters cannot continue to be reduced. FIG. 1 is a top view of a vertical cavity surface emitting laser in related art. FIG. 2 is a top view of another vertical cavity surface emitting laser in related art. FIG. 3 is a sectional diagram taken along a line A1-A2 of FIG. 1. Referring to FIGS. 1 to 3, the applicant has carefully studied that the vertical cavity surface emitting laser in the related art includes a substrate 10 and emitters 20 arranged in an array, where the emitters 20 are located on a surface of the substrate 10 or an epitaxial layer (not shown), and each emitter 20 includes a light emitting window 21, a via 22, and an oxidation trench 23. The via 22 and oxidation trench 23 of each emitter surround the light emitting window 21, the via 22 surrounds the light emitting window 21, and the oxidation trench 23 surrounds the via 22.There is no shared via 22 between emitters 20, and there is no shared oxidation trench 23 between emitters 20. Therefore, an area of the spare space between the emitters 20 is relatively large, so that the size between the emitters 20 cannot be further reduced. A first pad 25 is not shown in FIG. 1. The first pad 25, the first passivation layer 24, a first pad metal contact layer 25a and a second pad 29 are further shown in FIG. 3.

To solve the above problem, embodiments of the present disclosure provide the solutions described below.

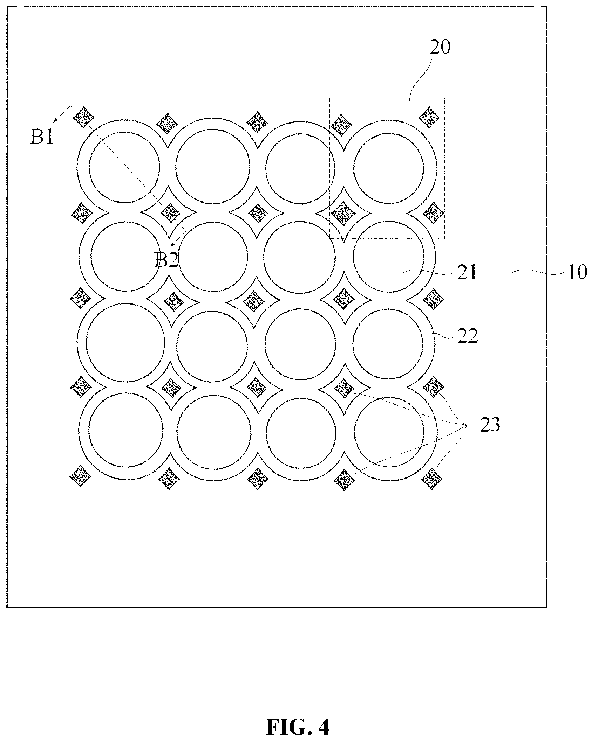

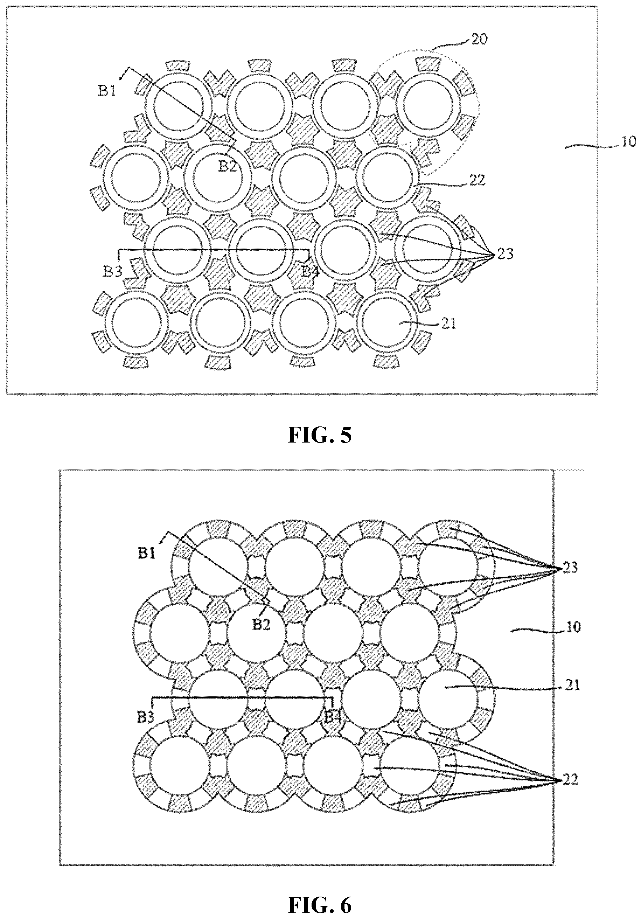

FIG. 4 is a structural diagram of a vertical cavity surface emitting laser according to an embodiment of the present application. FIG. 5 is a structural diagram of another vertical cavity surface emitting laser according to an embodiment of the present application. Referring to FIGS. 4 and 5, the vertical cavity surface emitting laser includes a substrate 10, and emitters 20 arranged in an array, where the emitters 20 are located on a surface of the substrate 10. Each emitter 20 includes a light emitting window 21, a via 22 and an oxidation trench 23. The light emitting window 21 is used for transmitting light, the via 22 surrounds the light emitting window 21, and the oxidation trench 23 surrounds the light emitting window 22, and at least one of the via 22 or the oxidation trench 23 is shared by at least two emitters 20.

It is to be noted that the via 22 is used for placing a pad for providing an electrical signal to the emitter 20. The pad may be a P-type pad or an N-type pad.

FIGS. 4 and 5 exemplarily illustrate sixteen emitters 20. The via 22 surrounds the light emitting window 21. Referring to FIG. 4, the via 22 is shared by the at least three emitters 20. It is to be noted that not shown in drawings, when there is a row or a column of emitters 20, the via 22 is shared by at least two emitters 20.

Referring to FIGS. 4 and 5, the oxidation trench 23 surrounds the light emitting window 21. In FIG. 4, one oxidation trench 23 is shared by four emitters 20. In FIG. 5, one oxidation trench 23 is shared by at least three emitters 20. It is to be noted that not shown in drawings, when there is a row or a column of emitters 20, the oxidation trench 23 is shared by at least two emitters 20.

In the solution provided by the embodiment of the present application, at least one of the via 22 or the oxidation trench 23 is shared by at least two emitters 20. Compared with the solution in which there is no shared via 22 between the emitters 20 and no shared oxidation trench 23 between the emitters 20, at least one of the via 22 or the oxidation trench 23 is shared by different emitters 20, and at least one of the via 22 or the oxidation trench 23 can occupy an spare space between the emitters 20, thereby reducing the size between the emitters 20, further increasing the density of the emitters 20 and the power density of the vertical cavity surface emitting laser.

FIG. 6 is a top view of another vertical cavity surface emitting laser according to an embodiment of the present application. Referring to FIGS. 4 to 6, in an embodiment, the oxidation trench 23 surrounding the same light emitting window 21 includes S oxidation sub-trenches, where a value of S includes an even greater than or equal to 2; and/or the via 22 surrounding the same light emitting window includes Q sub-vias, where a value of Q includes an even greater than or equal to 2, and a projection area of the S oxidation sub-trenches on the substrate and a projection area of the Q sub-vias on the substrate may not overlap.

Exemplarily, referring to FIG. 4, the oxidation trench 23 includes four oxidation sub-trenches. Exemplarily, referring to FIG. 5, the oxidation trench 23 includes six oxidation sub-trenches. Referring to FIG. 6, the via 22 surrounding the same light emitting window 21 includes six sub-vias, where a gap between the boundary of the oxidation sub-trenches and the boundary of the via 22, that is, the projection area of the oxidation sub-trenches on the substrate 10, and the projection area of the via 22 on the substrate 10 may not overlap.

For example, compared to the oxidation trench 23, which is a monolithic in the vertical cavity surface emitting laser, in the embodiment of the present application, the oxidation trench 23 is arranged as a plurality of spaced oxidation sub-trenches, and the oxidation sub-trenches can be arranged in a spare space between emitters 20, thereby further reducing the size between the emitters 20, and further improving the density of the emitters 20, and the power density of the vertical cavity surface emitting laser. Compared to the via 22, which is a monolithic in the vertical cavity surface emitting laser, in the embodiment of the present application, the via 22 is arranged as a plurality of spaced sub-vias, and the sub-vias can be arranged in a spare space between the emitters 20, thereby further reducing the size between the emitters 20, and further improving the density of the emitters 20 and the power density of the vertical cavity surface emitting laser.

In an embodiment, on the basic of the above solutions, referring to FIGS. 4 to 6, the S oxidation sub-trenches are arranged at equal intervals in a circumferential direction of the same light emitting window 21.

For example, the S oxidation sub-trenches are arranged at equal intervals in the circumferential direction of the same light emitting window 21, thus simplifying the difficulty of arranging the S oxidation sub-trenches in the oxidation trench 23.

In an embodiment, on the basic of the above solutions, the Q sub-vias are arranged at equal intervals in a circumferential direction of the same light emitting window 21.

For example, the Q sub-vias are arranged at equal intervals in the circumferential direction of the same light emitting window 21, thus simplifying the difficulty of arranging the Q sub-vias in the via 22.

In an embodiment, on the basic of the above solutions, referring to FIG. 6, in a circumferential direction of the same light emitting window 21, the oxidation sub-trenches surrounding the same light emitting window 21, the sub-vias surrounding the same light emitting window 21 are alternatively arranged.

For example, in the circumferential direction of the same light emitting window 21, the oxidation sub-trenches surrounding the same light emitting window 21, and the sub-vias surrounding the same light emitting window 21 are alternatively arranged, and the via 22 and the oxidation trench 23 together enclose one light emitting window 21, thereby further reducing the distance between the oxidation trench 23 and the light emitting window 21, further reducing the size between the emitters 20, and further improving the density of the emitters 20 and the power density of the vertical cavity surface emitting laser.

In an embodiment, on the basic of the above solutions, referring to FIG. 6, a spacing between one side of each of the oxidation sub-trenches surrounding the same light emitting window 21 adjacent to the light emitting window 21 and the light emitting window 21 is equal to a spacing between one side of each of the sub-vias surrounding the same light emitting window 21 adjacent to the light emitting window 21 and the light emitting window 21.

For example, the light emitting window 21 is enclosed together by the oxidation sub-trenches and the sub-vias, compared with a solution in which the spacing between one side of the oxidation trench adjacent to the light emitting window 21 and the light emitting window 21 is greater than the spacing between one side of the via adjacent to the light emitting window 21 and the light emitting window 21, the solution provided by the embodiment of the present application further reduces the distance between the oxidation trench 23 and the light emitting window 21, further reduces the size between the emitters 20, and further improves the density of the emitters 20 and the power density of the vertical cavity surface emitting laser.

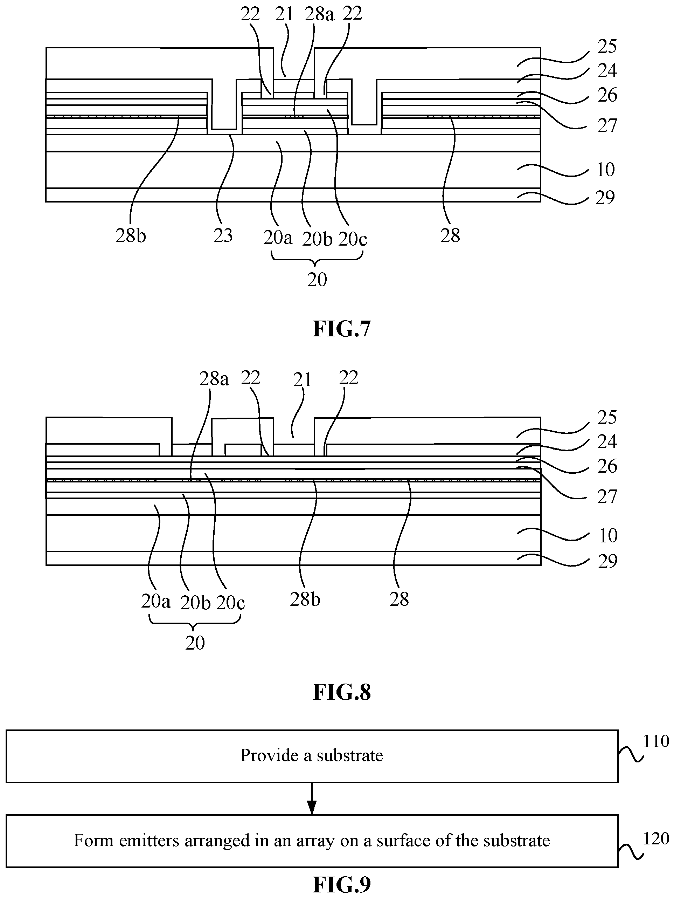

FIG. 7 is a sectional diagram taken along a line B1-B2 of FIGS. 4 to 6. FIG. 8 is a sectional diagram taken along a line B3-B4 of FIGS. 5 and 6. It is noted that the first pad 25 is not shown in the top views of FIGS. 4 to 6. In an embodiment, on the basic of the above solutions, referring to FIG. 7, the emitters 20 include a first reflector 20a, an active layer 20b, a second reflector 20c, a first passivation layer 24, and a first pad 25. The first reflector 20a is located on a surface of the substrate 10. The active layer 20b is located on a surface of the first reflector 20a away from the substrate 10. The second reflector 20c is located on a surface of the active layer 20b away from the substrate 10, a surface of the second reflector 20c away from the substrate 10 is provided with the oxidation trench 23, and the oxidation trench 23 penetrates the second reflector 20c, the active layer 20b and a portion of the first reflector 20a. The first passivation layer 24 covers a surface of a side of the second reflector 20c away from the substrate 10, and a bottom surface and a side surface of the oxidation trench 23, the first passivation layer 24 includes the via 22, and the second reflector 20c is partially exposed from a projection of the via 22 on the substrate 10. The first pad 25 is located on a surface of the first passivation layer 24 away from the substrate 10, and the first pad 25 is connected to the second reflector 20c through the via 22.

For example, the first passivation layer 24 may achieve electrical insulation between the first pad 25 and the first reflector 20a. In an embodiment, the vertical cavity surface emitting laser further includes a second pad 29 located on a side of the substrate 10 away from the emitters 20. Exemplarily, when the first pad 25 is a P-type pad, the second pad 29 is an N-type pad. When the first pad 25 is an N-type pad, the second pad 29 is a P-type pad. It can be seen that the refractive index of the first reflector 20a is different from the refractive index of the second reflector 20c, and the first reflector 20a and the second reflector 20c are formed by periodically growing a semiconductor material having an optical thickness of an odd multiple of one quarter of wavelength. The active layer 20b is a quantum well light-emitting material, which emits light under action of the current signal, and the emitted light is reflected between the first reflector 20a and the second reflector 20c and is emitted from the second reflector 20c. Embodiments of the present application include the solution in which the light emitted from the second reflector 20c of the vertical cavity surface emitting laser shown in the drawings, and may also include the solution in which the light emitted from the first reflector 20a of the vertical cavity surface emitting laser.

For example, the first pad 25 applies a first current signal to the second reflector 20c, where a first ohmic contact layer 27 is formed on the surface of the second reflector 20c away from the substrate 10, that is, the first ohmic contact layer 27 is disposed between the first pad 25 and the second reflector 20c. The first reflector 20a of each emitter 20 acquires a second current signal through the second pad 29. The active layer 20b emits light under action of the current signal, and the emitted light is reflected between the first reflector 20a and the second reflector 20c, and is emitted from the second reflector 20c. Corresponding to FIGS. 4 and 5, a region surrounded by the via 22 is the light emitting window 21. Corresponding to FIG. 6, a region surrounded by the via 22 and the oxidation trench 23 is the light emitting window 21. A first pad ohmic metal layer is not provided between the first pad 25 and the second reflector 20c in the embodiment of the present application, the space in the horizontal direction occupied by the first pad metal contact layer can be omitted for accommodating the oxidation trench 23, thereby further reducing the distance between the oxidation trench 23 and the light emitting window 21, further reducing the size between the emitters 20, and further improving the density of the emitters 20 and the power density of the vertical cavity surface emitting laser.

In an embodiment, referring to FIGS. 7 and 8, on the basic of the above solutions, the vertical cavity surface emitting laser further includes a second passivation layer 26, where the second passivation layer 26 is located between the first passivation layer 24 and the second reflector 20c, and the via 22 penetrates the second passivation layer 26.

For example, when the oxidation trench 23 is formed, the second passivation layer 26 can protect the film layer corresponding to the emitters 20. It is to be noted that the first passivation layer 24 and the second passivation layer 26 can transmit light emitted from the emitters 20 by controlling the thicknesses of the first passivation layer 24 and the second passivation layer 26.

In an embodiment, after the first ohmic contact layer 27 is formed, the second passivation layer 26 may also be located between the first passivation layer 24 and the first ohmic contact layer 27.

In an embodiment, on the basic of the above solutions, referring to FIG. 7 and 8, the vertical cavity surface emitting laser further includes an oxidized layer 28b, where the oxidized layer 28b is located within the second reflector 20c, an oxidation aperture 28a is enclosed by the oxidized layer 28b, and a projection of the oxidation aperture 28a on the substrate 10 is located within a projection of the light emitting window 21 on the substrate 10.

For example, the oxidation aperture 28a is surrounded by the oxidized layer 28b, an aluminum component layer 28 is oxidized to form the oxidized layer 28b, and the oxidation aperture 28a is an unoxidized aluminum component layer. The aluminum component layer may be a AlAs or AlGaAs layer. The proportion of the aluminum component in the aluminum component layer is highest in the second reflector 20c. The size of the oxidation aperture 28a may define the size of the light-emitting point in the light emitting window 21.

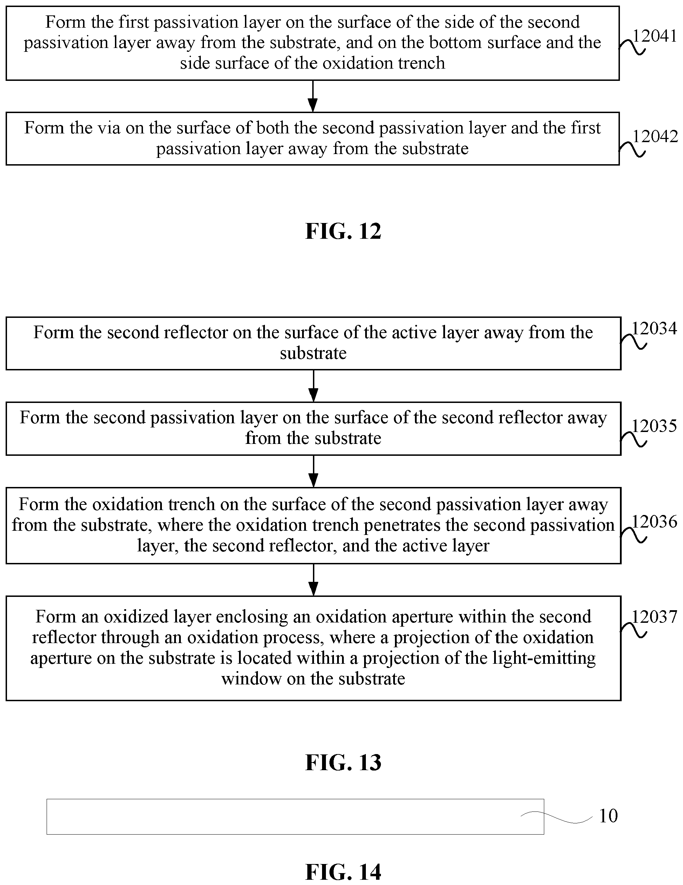

FIG. 9 is a flowchart of a manufacturing method of a vertical cavity surface emitting laser according to an embodiment of the present application. FIGS. 14 to 22 are structural diagrams corresponding to various steps of a manufacturing method of a vertical cavity surface emitting laser according to an embodiment of the present application.

An embodiment of the present application further provides a manufacturing method of a vertical cavity emitting laser. Referring to FIG. 9, the method includes steps described below.

In step 110, a substrate is provided.

Referring to FIG. 14, a substrate 10 is provided. The substrate 10 may be selected as a semiconductor material, such as a gallium arsenide semiconductor material.

In step 120, emitters arranged in an array are formed on a surface of the substrate.

Each emitter includes a light emitting window, a via and an oxidation trench. The light emitting window is used for emitting light, the via surrounds the light emitting window, and the oxidation trench surrounds the light emitting window. At least one of the via or the oxidation trench is shared by at least two of the emitters.

Referring to FIGS. 4 and 6, the emitters 20 are arranged in the array on the surface of the substrate. Each emitter 20 is provided with light emitting window 21, a via 22 and an oxidation trench 23, the light emitting window 21 is used for emitting light, the via 22 surrounds the light emitting window 21, and the oxidation trench 23 surrounds the light emitting window 21. At least one of the via 22 or the oxidation trench 23 is shared by at least two of the emitters 20.

Exemplarily, referring to FIGS. 4 and 5, FIGS. 4 and 5 exemplarily illustrate sixteen emitters 20. The via 22 surrounds the light emitting window 21. Referring to FIG. 4, the via 22 is shared by four emitters 20. It is to be noted that not shown in drawings, when there are a row or a column of emitters 20, the via 22 is shared by two emitters 20.

Referring to FIGS. 4 and 5, the oxidation trench 23 surrounds the light emitting window 21. In FIG. 4, the oxidation trench 23 is shared by four emitters 20. In FIG. 5, the oxidation trench 23 is shared by three emitters 20. It is to be noted that not shown in drawings, when there are a row or a column of emitters 20, the oxidation trench 23 is shared by two emitters 20.

In the solution provided by the embodiment of the present application, at least one of the via 22 or the oxidation trench 23 is shared by at least two emitters 20. Compared with the solution in which there is no shared via 22 between the emitters 20, and no shared oxidation trench 23 between the emitters 20, at least one of the via 22 or the oxidation trench 23 is shared by different emitters 20, and at least one of the via 22 or the oxidation trench 23 can occupy a spare space between the emitters 20, thereby reducing the size between the emitters 20, further increasing the density of the emitters 20 and the light-emitting power density of the vertical cavity surface emitting laser.

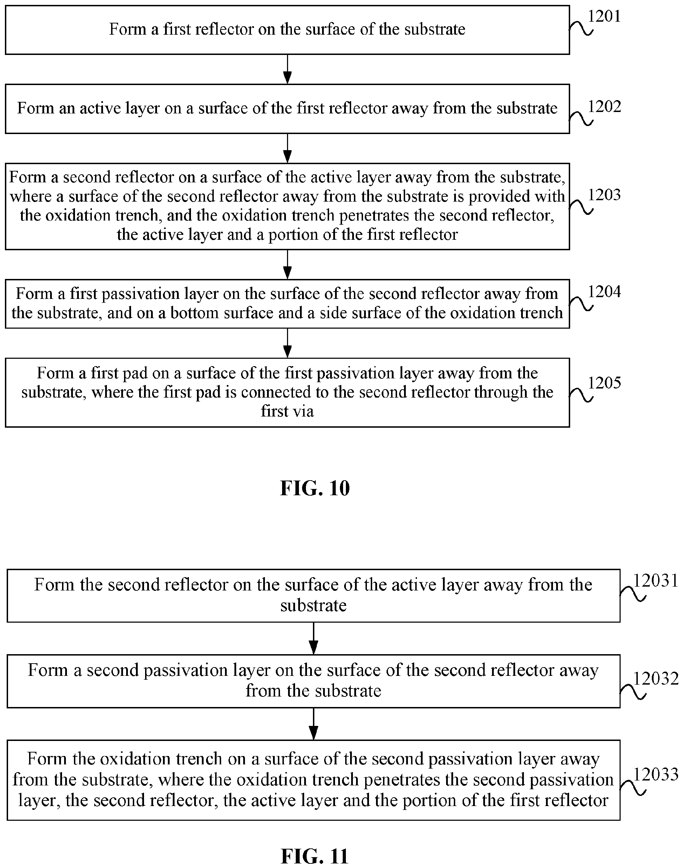

FIG. 10 is a flowchart included in step 120 of FIG. 9. In an embodiment, referring to FIG. 10, the step 120 in which the emitters arranged in an array are formed on the surface of the substrate includes the steps described below.

In step 1201, a first reflector is formed on the surface of the substrate.

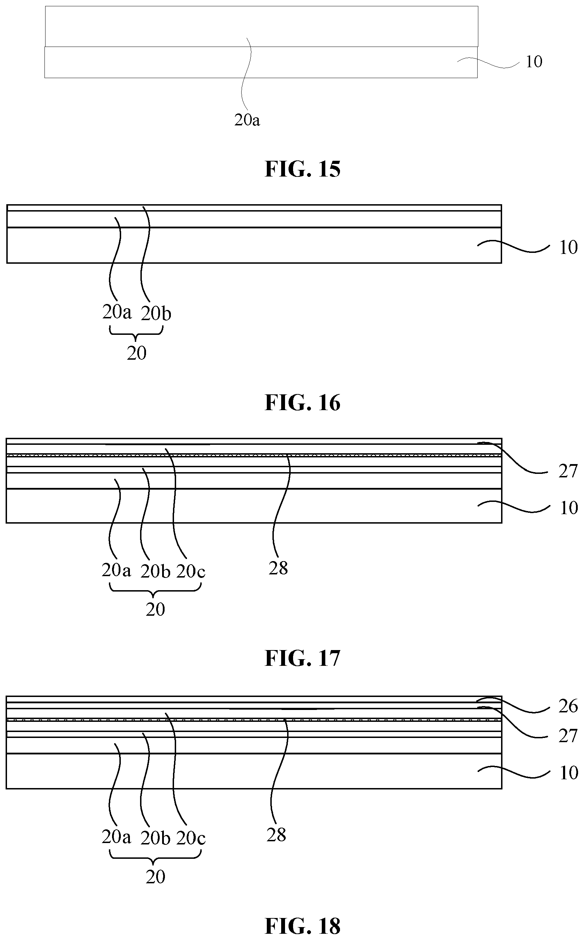

Referring to FIG. 15, the first reflector 20a is formed on the surface of the substrate 10.

In step 1202, an active layer is formed on a surface of the first reflector away from the substrate.

Referring to FIG. 16, the active layer 20b is formed on the surface of the first reflector 20a away from the substrate 10.

In step 1203, a second reflector is formed on a surface of the active layer away from the substrate, where a surface of the second reflector away from the substrate is provided with the oxidation trench, and the oxidation trench penetrates the second reflector, the active layer and a portion of the first reflector.

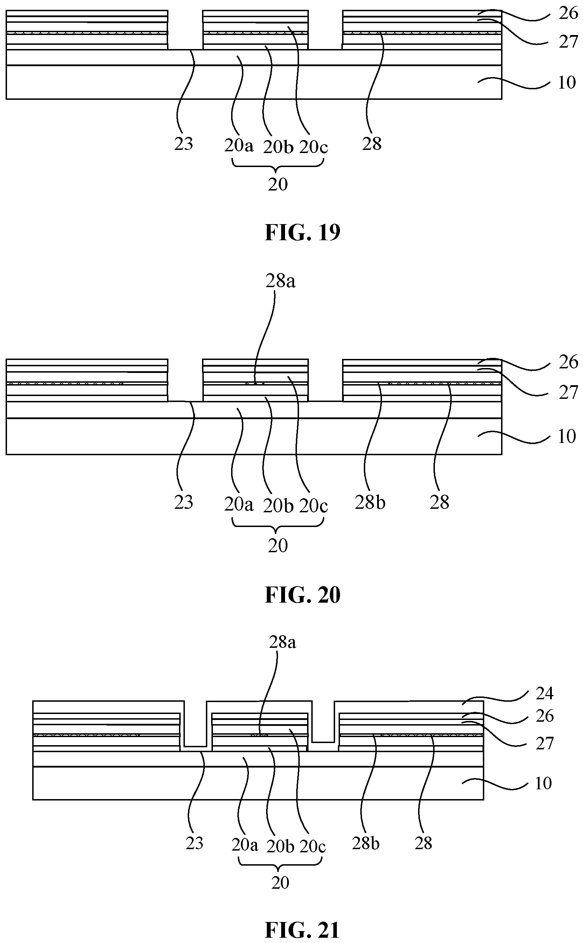

Referring to FIG. 19, the second reflector 20c is formed on the surface of the active layer 20b away from the substrate 10, where the surface of the second reflector 20c away from the substrate 10 is provided with the oxidation trench 23, and the oxidation trench 23 penetrates the second reflector 20c, the active layer 20b and a portion of the first reflector 20a.

In step 1204, a first passivation layer is formed on a surface of a side of the second reflector away from the substrate, and on a bottom surface and a side surface of the oxidation trench.

A surface of the first passivation layer away from the substrate is provided with the via, and the second reflector is partially exposed from a projection of the via on the substrate.

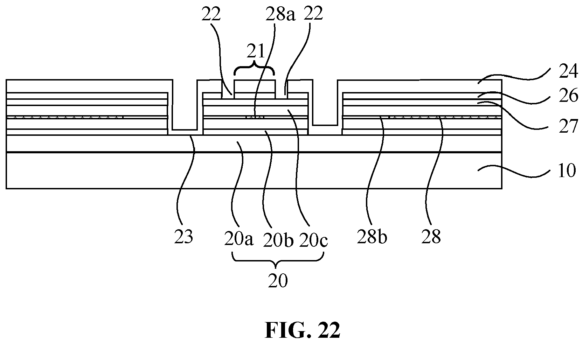

Referring to FIGS. 21 and 22, the first passivation 24 is formed on the surface of the side of the second reflector 20c away from the substrate 10, and on the bottom surface and the side surface of the oxidation trench 23, where the surface of the first passivation layer 24 away from the substrate 10 is provided with the via 22, and the first ohmic contact layer 27 is partially exposed from the projection of the via 22 on the substrate 10. The first passivation layer 24 may achieve electrical insulation between the first pad 25 and the first reflector 20a.

In step 1205, a first pad is formed on a surface of the first passivation layer away from the substrate, where the first pad is connected to the second reflector through the via.

Referring to FIG. 7, the first pad 25 is formed on the surface of the first passivation layer away from the substrate, where the first pad 25 is connected to the second reflector 20c through the via 22.

The first pad metal contact layer is not provided on the first pad 25 and the second reflector 20c in the embodiment of the present application, the space in the horizontal direction occupied by the first pad metal contact layer can be omitted for accommodating the oxidation trench 23, thereby further reducing the distance between the oxidation trench 23 and the light emitting window 21, further reducing the size between the emitters 20, and further improving the density of the emitters 20 and the light-emitting power density of the vertical cavity surface emitting laser.

In an embodiment, referring to FIG. 7, after the first pad 25 is formed, the second pad 29 may be formed on a surface of a side of the substrate 10 away from the emitters 20.

It can be seen that the refractive index of the first reflector 20a is different from the refractive index of the second reflector 20c, and the first reflector 20a and the second reflector 20c are formed by periodically growing a semiconductor material having an optical thickness of an odd multiple of one quarter of wavelength. The active layer 20b is a quantum well light-emitting material, which emits light under action of the current signal, and the emitted light is reflected between the first reflector 20a and the second reflector 20c and is emitted from the second reflector 20c. Embodiments of the present application include the solution in which the light emitted from the vertical cavity surface emitting laser shown in the drawings is emitted from the second reflector 20c, and may also include the solution in which the light emitted from the vertical cavity surface emitting laser is emitted from the first reflector 20a.

For example, the first pad 25 applies a first current signal to the second reflector 20c, where a first ohmic contact layer 27 is formed on the surface of the second reflector 20c away from the substrate 10, that is, the first ohmic contact layer 27 is disposed between the first pad 25 and the second reflector 20c. The first reflector 20a of each emitter 20 acquires a second current signal through the second pad 29. The active layer 20b emits light under action of the current signal, and the emitted light is reflected between the first reflector 20a and the second reflector 20c and is emitted from the second reflector 20c. Corresponding to FIGS. 4 and 5, a region surrounded by the via 22 is the light emitting window 21. Corresponding to FIG. 6, a region surrounded by the via 22 and the oxidation trench 23 is the light emitting window 21.

FIG. 11 is a flowchart included in step 1203 of FIG. 10. In an embodiment, referring to FIG. 11, the step 1203 in which the second reflector is formed on the surface of the active layer away from the substrate includes the steps described below.

In step 12031, the second reflector is formed on the surface of the active layer away from the substrate.

Referring to FIG. 17, the second reflector 20c is formed on the surface of the active layer 20b away from the substrate 10.

In an embodiment, referring to FIG. 17, after the second reflector 20c is formed on the surface of the active layer 20b away from the substrate 10, the first ohmic contact layer 27 may further be formed on the surface of the active layer 20b away from the substrate 10. For example, the first ohmic contact layer 27 may achieve good ohmic contact between the first pad 25 and the second reflector 20c.

In step 12032, the second passivation layer is formed on the surface of the second reflector away from the substrate.

Referring to FIG. 18, the second passivation layer 26 is formed on the surface of the second reflector 20c away from the substrate 10. For example, when the oxidation trench 23 is formed, the second passivation layer 26 can protect the film layer corresponding to the emitters 20.

In step 12033, the oxidation trench is forming on the surface of the second passivation layer away from the substrate, where the oxidation trench penetrates the second passivation layer, the second reflector, the active layer and a portion of the first reflector.

Referring to FIG. 19, the oxidation trench 23 is formed on the surface of the second passivation layer 26 away from the substrate 10, where the oxidation trench 23 penetrates the second passivation layer 26, the second reflector 20c, the active layer 20b and a portion of the first reflector 20a.

FIG. 12 is a flowchart included in step 1204 of FIG. 10. Correspondingly, referring to FIG. 12, the step 1204 in which the first passivation layer is formed on the surface of the side of the second reflector away from the substrate, and on the bottom surface and the side surface of the oxidation trench includes the steps described below.

In step 12041, the first passivation layer is formed on the surface of the side of the second passivation layer away from the substrate, and on the bottom surface and the side surface of the oxidation trench.

Referring to FIG. 21, the first passivation layer 24 is formed on the surface of the side of the second passivation layer 26 away from the substrate 10, and on the bottom surface and the side surface of the oxidation trench 23.

In step 12042, the via is formed on the surfaces of both the second passivation layer and the first passivation layer away from the substrate.

The second reflector is partially exposed from the projection of the via on the substrate.

Referring to FIG. 22, the via 22 is formed on the surface of both the second passivation layer 26 and the first passivation layer 24 away from the substrate 10, where the first ohmic contact layer 27 is partially exposed from the projection of the via 22 on the substrate 10.

FIG. 13 is another flowchart included in step 1203 of FIG. 10. In an embodiment, referring to FIG. 13, the step 1203 in which the second reflector is formed on the surface of the active layer away from the substrate includes the steps described below.

In step 12034, the second reflector is formed on the surface of the active layer away from the substrate.

Referring to FIG. 17, the second reflector 20c is formed on the surface of the active layer 20b away from the substrate 10. The aluminum component layer 28 is included inside the second reflector 20c. The proportion of the aluminum component in the aluminum component layer 28 is highest in the second reflector 20c.

In step 12035, the second passivation layer is formed on the surface of the second reflector away from the substrate.

Referring to FIG. 18, the second passivation layer 26 is formed on the surface of the second reflector 20c away from the substrate 10.

In step 12036, the oxidation trench is formed on the surface of the second passivation layer away from the substrate, where the oxidation trench penetrates the second passivation layer, the second reflector, and the active layer.

Referring to FIG. 19, the oxidation trench 23 is formed on the surface of the second passivation layer 26 away from the substrate 10, where the oxidation trench 23 penetrates the second passivation layer 26, the second reflector 20c, and the active layer 20b.

In step 12037, an oxidized layer enclosing an oxidation aperture is formed within the second reflector through an oxidation process, where a projection of the oxidation aperture on the substrate is located within a projection of the light emitting window on the substrate.

Referring to FIG. 20, the oxidized layer 28b enclosing the oxidation aperture 28a is formed within the second reflector 20c through the oxidation process, where the projection of the oxidation aperture 28a on the substrate 10 is located within the projection of the light emitting window 21 on the substrate 10. For example, the aluminum component layer 28 is oxidized to form the oxidized layer 28b, and the oxidation aperture 28a is an unoxidized aluminum component layer 28. The aluminum component layer 28 may be a AlAs or AlGaAs layer. The size of the oxidation aperture 28a may define the size of the light-emitting point in the light emitting window 21.

In the solution provided by the embodiment of the present application, at least one of the via or the oxidation trench is shared by at least two emitters. Compared with the solution in which there is no shared via between the emitters and no shared oxidation trench between the emitters, at least one of the via or the oxidation trench is shared by different emitters, and at least one of the via or the oxidation trench can occupy a spare space between the emitters, thereby reducing the size between the emitters, further increasing the density of the emitters and the light-emitting power density of the vertical cavity surface emitting laser.

It is to be noted that the preceding are only some embodiments of the present application and the technical principles used therein. It is to be understood by those skilled in the art that the present application is not limited to the embodiments described herein. For those skilled in the art, various apparent modifications, adaptations and substitutions may be made without departing from the scope of the present application. Therefore, while the present application is described in detail in connection with the preceding embodiments, the present application is not limited to the preceding embodiments and may include equivalent embodiments without departing from the concept of the present application. The scope of the present application is determined by the scope of the appended claims.

## Claims

1. A vertical cavity surface emitting laser, comprising:
a substrate (10); and
emitters (20) arranged in an array, wherein the emitters (20) are located on a surface of the substrate (10);
wherein each emitter (20) of the emitters (20) is provided with a light emitting window (21), a via (22) and an oxidation trench (23), the light emitting window (21) is used for emitting light, the via (22) surrounds the light emitting window (21), and the oxidation trench (23) surrounds the light emitting window (21); and
wherein at least one of the via (22) or the oxidation trench (23) is shared by at least two of the emitters (20).

2. The vertical cavity surface emitting laser of claim 1, wherein the oxidation trench (23) surrounding a same light emitting window (21) comprises S oxidation sub-trenches, and a value of S comprises an even number greater than or equal to 2; and/or
the via (22) surrounding a same light emitting window (21) comprises Q sub-vias, and a value of Q comprises an even number greater than or equal to 2.

3. The vertical cavity surface emitting laser of claim 2, wherein
the S oxidation sub-trenches are arranged at equal intervals in a circumferential direction of the same light emitting window (21).

4. The vertical cavity surface emitting laser of claim 2, wherein
the Q sub-vias are arranged at equal intervals in a circumferential direction of the same light emitting window (21).

5. The vertical cavity surface emitting laser of claim 2, wherein in a circumferential direction of the same light emitting window (21), the S oxidation sub-trenches surrounding the same light emitting hole (21), and the Q sub-vias surrounding the same light emitting hole (21) are alternatively arranged, and a projection area of the S oxidation sub-trenches on the substrate (10), and a projection area of the Q sub-vias on the substrate (10) do not overlap.

6. The vertical cavity surface emitting laser of claim 5, wherein a spacing between one side of each of the S oxidation sub-trenches surrounding the same light emitting window (21) adjacent to the light emitting hole (21) and the light emitting window (21) is equal to a spacing between one side of each of the Q sub-vias surrounding the same light emitting window (21) adjacent to the light emitting hole (21) and the light emitting window (21).

7. The vertical cavity surface emitting laser of claim 1, wherein each of the emitters (20) comprises:
a first reflector (20a), wherein the first reflector (20a) is located on a surface of the substrate (10);
an active layer (20b), wherein the active layer (20b) is located on a surface of the first reflector (20a) away from the substrate (10);
a second reflector (20c), wherein the second reflector (20c) is located on a surface of the active layer (20b) away from the substrate (10), a surface of the second reflector (20c) away from the substrate (10) is provided with the oxidation trench (23), and the oxidation trench (23) penetrates the second reflector (20c), the active layer (20b) and a portion of the first reflector (20a);
a first passivation layer (24), wherein the first passivation layer (24) covers a surface of a side of the second reflector (20c) away from the substrate (10), and a bottom surface and a side surface of the oxidation trench (23), the first passivation layer (24) is provided with the via (22), and the second reflector (20c) is partially exposed from a projection of the via (22) on the substrate (10); and
a first pad (25), wherein the first pad (25) is located on a surface of the first passivation layer (24) away from the substrate (10), and the first pad (25) is connected to the second reflector (20c) through the via (22).

8. The vertical cavity surface emitting laser of claim 7, further comprising a second passivation layer (26), wherein the second passivation layer (26) is located between the first passivation layer (24) and the second reflector (20c), and the via (22) penetrates the second passivation layer (26).

9. The vertical cavity surface emitting laser of claim 7, further comprising an oxidized layer (28b), wherein the oxidized layer (28b) is located within the second reflector (20c), an oxidation aperture (28a) is enclosed by the oxidized layer (28b), and a projection of the oxidation aperture (28a) on the substrate (10) is located within a projection of the light emitting window (21) on the substrate.

10. A manufacturing method of a vertical cavity surface emitting laser, comprising:
providing a substrate (10); and
forming emitters arranged in an array on a surface of the substrate (10);
wherein each emitter (20) of the emitters (20) comprises a light emitting window (21), a via (22) and an oxidation trench (23), the light emitting window (21) is used for emitting light, the via (22) surrounds the light emitting window (21), and the oxidation trench (23) surrounds the light emitting window (21); and
wherein at least one of the via (22) and the oxidation trench (23) is shared by at least two of the emitters (20).

11. The manufacturing method of the vertical cavity surface emitting laser of claim 10, wherein forming the emitters arranged in the array on the surface of the substrate (10) comprises:
forming a first reflector (20a) on the surface of the substrate (10);
forming an active layer (20b) on a surface of the first reflector (20a) away from the substrate (10);
forming a second reflector (20c) on a surface of the active layer (20b) away from the substrate (10), wherein a surface of the second reflector (20c) away from the substrate (10) is provided with the oxidation trench (23), and the oxidation trench (23) penetrates the second reflector (20c), the active layer (20b) and a portion of the first reflector (20a);
forming a first passivation layer (24) on a surface of a side of the second reflector (20c) away from the substrate (10), and on a bottom surface and a side surface of the oxidation trench (23), wherein a surface of the first passivation layer (24) away from the substrate (10) is provided with the via (22), and the second reflector (20c) is partially exposed from a projection of the via (22) on the substrate (10); and
forming a first pad (25) on a surface of the first passivation layer (24) away from the substrate (10), wherein the first pad (25) is connected to the second reflector (20c) through the via (22).

12. The manufacturing method of the vertical cavity surface emitting laser of claim 11, wherein after forming the second reflector (20c) on the surface of the active layer (20b) away from the substrate (10), the manufacturing method of the vertical cavity surface emitting laser further comprises:
forming a second passivation layer (26) on a surface of the second reflector (20c) away from the substrate (10); and
forming the oxidation trench (23) on a surface of the second passivation layer (26) away from the substrate (10), wherein the oxidation trench (23) penetrates the second passivation layer (26), the second reflector (20c), the active layer (20b) and the portion of the first reflector (20a);
wherein forming the first passivation layer (24) on the surface of the side of the second reflector (20c) away from the substrate (10), and on the bottom surface and the side surface of the oxidation trench (23), comprises:
forming the first passivation layer (24) on a surface of a side of the second passivation layer (26) away from the substrate (10), and on the bottom surface and the side surface of the oxidation trench (23); and
forming the via (22) on surfaces of both the second passivation layer (26) and the first passivation layer (24) away from the substrate (10), wherein the second reflector (20c) is partially exposed from the projection of the via (22) on the substrate (10).

13. The manufacturing method of the vertical cavity surface emitting laser of claim 11, wherein after forming the second reflector (20c) on the surface of the active layer (20b) away from the substrate (10), the manufacturing method of the vertical cavity surface emitting laser further comprises:
forming a second passivation layer (26) on a surface of the second reflector (20c) away from the substrate (10);
forming the oxidation trench (23) on a surface of the second passivation layer (26) away from the substrate (10), wherein the oxidation trench (23) penetrates the second passivation layer (26), the second reflector (20c), the active layer (20b) and the portion of the first reflector (20a); and
forming an oxidized layer (28b) enclosing an oxidation aperture (28a) within the second reflector (20c) through an oxidation process, wherein a projection of the oxidation aperture (28a) on the substrate (10) is located within a projection of the light emitting window (21) on the substrate.
